(19) Europäisches Patentamt
European Patent Office
Office européen des brevets

(11) Publication number: 0 331 448
A2

(12) # EUROPEAN PATENT APPLICATION

(21) Application number: 89302008.1

(22) Date of filing: 28.02.89

(51) Int. Cl.4: C 07 F 5/06
C 23 C 16/34

(30) Priority: 29.02.88 GB 8804707
08.03.88 GB 8805524

(43) Date of publication of application:
06.09.89 Bulletin 89/36

(84) Designated Contracting States: DE FR GB NL

(71) Applicant: Bradley, Donald Charlton
171 Shakespear & Tower Barbican
London EC2Y 8DR (GB)

Frigo, Dario Marcello
Flat 43, Park House 314-322 Seven Sisters Road
London N4 2LR (GB)

White, Eric Alfred Dutton
Green Farm Plough Road
Smallfield Horley Surrey RH6 9JN (GB)

(72) Inventor: Bradley, Donald Charlton
171 Shakespear & Tower Barbican
London EC2Y 8DR (GB)

Frigo, Dario Marcello
Flat 43, Park House 314-322 Seven Sisters Road
London N4 2LR (GB)

White, Eric Alfred Dutton
Green Farm Plough Road
Smallfield Horley Surrey RH6 9JN (GB)

(74) Representative: Neville, Peter Warwick
Patent Department National Research Development
Corporation 101 Newington Causeway
London SE1 6BU (GB)

(54) **Forming aluminium nitride films.**

(57) Aluminium nitride films are formed in a simple reactor comprising an evaporation chamber held at a temperature between 80°C and 150°C, connected to a reactor containing substrates on-which film deposition is required, heated to a higher temperature between 500°C and 900°C. The evaporation chamber contains a vapour of the novel compound $(CH_3)_2$-Al-N-(isopropyl)$_2$, which decomposes on reaching the heated substrates to release Al and M as AlN films.

EP 0 331 448 A2

**Description**

## FORMING ALUMINIUM NITRIDE FILMS

This invention relates to a novel aluminium-nitrogen compound and to a method of forming a layer of aluminium nitride using the compound. Aluminium nitride is of importance in semiconductor devices because of its high thermal conductivity and high electrical resistivity. It can thus be used as a passive barrier layer or substrate for electronic hybrid circuit technologies where good dissipation of the heat generated by the circuits is required.

Conventionally, bulk aluminium nitride is formed by ceramic processes involving high temperature sintering reactions which form a dense bulk material, which is difficult to make in thin (nanometres) layer form. Thin layers conventionally can be deposited by the reaction of inorganic aluminium compounds, such as the halides, which are volatile at high temperatures and react in the vapour phase with ammonia or similar nitrogen containing volatile compounds to form aluminium nitride. These vapour deposition processes are cumbersome, requiring complex reactors for deposition at the high temperatures, normally in excess of 1000° C, needed for the reaction to proceed. Such equipment is both costly and inappropriate for large scale operation needed for semiconductor applications.

Another route to aluminium nitride deposits was proposed by Takahashi et al in Surface Science 86(1979)238-245. Aluminium tris-dialkylamides $[Al(NR_2)_3]_2$ were decomposed at 300-500° C to yield a layer which, however, on analysis yielded oxygen and carbon as well as aluminium and nitrogen. In place of those compounds, it would be desirable to have a compound which was non-hazardous, crystalline and easily (but not too easily) decomposable.

It is known from Interrante in Materials Research Society Symposium Proceedings 73(1986)986 that the trimer $\{(CH_3)_2AlNH_2\}_3$ will deposit AlN, but that compound is difficult to volatilise and also ammonia is present during the deposition, which can affect the deposit.

According to the present invention, there is provided a compound (which may be polymerised)

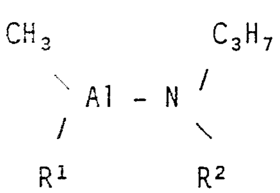

where $R^1$ is methyl, ethyl or n-propyl and $R^2$ is hydrogen, propyl, sec-butyl, tertiary butyl or aryl.

Preferably $R^1$ is methyl. Preferably $R^2$ is isopropyl.

This invention also provides a method forming a layer of aluminium nitride on a substrate, comprising heating the substrate to 500 to 900°C (or other suitable decomposition temperature) and exposing it to a vapour of (preferably solely of) a compound or compounds as set forth above. The vapour preferably contains substantially nothing else, or at least no other reactant compounds, or at least no other reactant compounds containing aluminium and/or nitrogen. The compounds according to the invention generally are volatile and readily sublimed in vacuo at temperatures typically between 70° C or 80° C and 150° C to give a molecular stream which (in the method according to the invention) may be introduced into either an evacuated hot-walled reactor tube or passed within a containing tube over locally heated surfaces (substrates) on which the deposition is required. The form of this apparatus is similar to reactors used in the process of Metallo-Organic Chemical Vapour Deposition (MOCVD), but with the essential difference that the present process operates in a high vacuum, advantageously under conditions of Knudsen flow rather than in the viscous flow regime appropriate to the higher gas pressures typical of MOCVD. Thus, in the method according to the invention, the vapour pressure is preferably at most $10^2$Pa, and thus is in an intermediate range between molecular beam epitaxy (MBE - ultra-high vacuum, below $10^{-6}$ Torr, $10^{-4}$ Pa) and MOCVD (above 10 Torr, $10^3$Pa). As a result of introducing the vapour in a controlled manner (preferably at a pressure of at least $10^{-1}$ Pa) into the reactor, decomposition of the said compound occurs on the heated surfaces with the consequent formation of aluminium nitride films, aluminium and nitrogen atoms being of course delivered in precisely equal numbers at any point.

In the present invention, the new compounds used in the method are dialkyl aluminium (mono/di)alkylamides. The alkyl groups attached to the aluminium are preferably groups which exert a shielding influence on the aluminium, minimising molecular interaction and leading to high volatility. It is important that these groups do not undergo a beta-elimination reaction which generally leads to decomposition paths resulting in the formation of metallic aluminium. Suitable groups are ethyl and especially methyl. The alkyl or aryl groups attached to the nitrogen are preferably those which <u>do</u> undergo β-elimination reactions in order that facile decomposition occurs between the temperatures 500° C and 900° C, e.g. both isopropyl. Since the β-elimination reaction results in the loss of an alkene, leaving a hydrogen atom attached to the nitrogen atom in the precursor molecule, it is also possible to use the compound $R^2 = H$.

These new compounds decompose at temperatures between 500° C and 800° C releasing both aluminium and nitrogen in equiatomic amounts forming layers of AlN. This binary compound is thus formed from a single precursor species and no other constituents or carrier gases are needed for film deposition.

This simplification compared with the conventional vapour deposition processes for AlN enables a simple and cheap apparatus, such as that to be

described, to be used for film deposition.

The physical nature of the AlN films formed depends on the decomposition temperature and on the surfaces on which it is deposited. When using amorphous surfaces at the lower temperature end of the range, viz. 500°C to 550°C the films produced are amorphous or very finely polycrystalline, with a mean crystallite size typically less than 1 micrometer. For higher growth temperatures the films consist of larger crystallites, above 1 micrometer in diameter. If the surfaces used for deposition are single crystal wafers of semiconductor materials such as silicon or gallium arsenide the layers formed consist of oriented cubic crystallites or epitaxial single crystal layers. For the formation of continuous, high density films it is preferable to use wafers which have but a small thermal expansion mismatch with AlN. The substrate can however be any material which is not damaged at the temperature involved. Silicon, silica glass and sapphire are examples.

The invention will now be described by way of example with reference to the accompanying drawings, in which

Figure 1 is a diagrammatic representation of metallo-organic molecular beam epitaxy apparatus used in the method according to the invention, and

Figure 2 shows an alternative arrangement for the growth chamber, a part of the apparatus of Figure 1.

The form of apparatus appropriate to metallo organic molecular beam epitaxial (MOMBE) deposition is shown diagrammatically in Figure 1. The precursor (the 'compound') is contained in an evacuated chamber 1, connected directly to a decomposition chamber 2 in which the surfaces for coating are arranged in any convenient manner provided that they are accessible to the vapour stream originating from the chamber 1. The precursor is vapourized by heating the chamber 1 to a temperature between 70°C and 150°C by means of a small thermostatically controlled oven 3. A larger electric furnace 4 is used to heat the surfaces on which deposition is required to temperatures between 500°C and 900°C. Chamber 2 is evacuated by means of a tube 5 through a trap 6, which can be immersed in liquid nitrogen or other appropriate coolants, which condense out any undecomposed precursor and reaction products. This trap can be isolated by means of valves 7 and 8 to allow disposal of the contents in a chemical work station. It is a feature of this method that no toxic materials or products need be involved. The apparatus is evacuated by means of rotary and diffusion pumps 9, 10, or by other types of high vacuum pumps such as molecular sieve, turbo molecular or titanium sublimation pumps.

An alternative version of the decomposition chamber 2 is shown in Figure 2 in which the surfaces to be coated with aluminium nitride films, 11, are locally heated by means of an infra-red lamp directed into the surfaces, or by means of a resistance heated plate or by an external radio frequency heating coil coupling to an internal susceptor 12. This arrangement has the advantage that decomposition of the precursor material does not occur on the reactor walls, and that a thermocouple 13 can be inserted into the susceptor or heat spreader to provide an accurate indication of the decomposition temperature for control purposes.

A particular feature of this apparatus is that the rate of volatilisation of the precursor material can be controlled by the temperature at which the precursor area is held by the oven 3. This enables the growth rate of the films to be controlled, which is important for reproducible operation of the equipment. Furthermore, the thickness uniformity of the films is better than in conventional vapour phase deposition of AlN since the gas flows are not subject to hydrodynamic restrictions which result in boundary layer effects and severe vapour depletion along the length of the decomposition chamber. Films showing interference fringes less than 1 wavelength of sodium light in variation across a wafer of 25mm diameter have been reproducibly attained.

As an example of a suitable precursor material the compound dimethylaluminium di-isopropylamide has been prepared and used for the growth of AlN films at 650°C which are dense, continuous and uniform which do not change their appearance after 48 hours' exposure to atmospheric moisture, and which adhere very strongly to the surfaces on which they were deposited. These surfaces include silica glass, silicon, sapphire, gallium arsenide, indium phosphide, metallic nickel and molybdenum. The structure of the film on silicon was epitaxial; layers could be grown at substrate temperatures from 600°C upwards. Layers grown at 500°C are apparently amorphous but on closer inspection prove to be composed of very small crystallites. As atmospheric moisture can penetrate just a small distance into the aluminium nitride lattice and degrade it, this structure (not surprisingly) deteriorated visibly in air within 48 hours.

A specific method according to the invention will now be described by way of example.

A solution of diisopropylamine $NH(CHMe_2)_2$ (3.15g, 31.2mmol) in pentane ($20cm^3$) was transferred dropwise onto a solution of $Me_3Al$ ($13cm^3$ of 2.3M solution in hexane, 30mmol) at -196°C. The contents were allowed to warm to 0°C and solvents were removed in vacuo to leave crude $Me_3Al.NH(CHMe_2)_2$. This was distilled at room temperature and 1Pa into a receiver flask at -78°C. The purified adduct was heated to 145°C under atmospheric pressure of nitrogen for one hour and the resulting solid was sublimed at 90°C/1Pa to give pure $[MeAlN(CHMe_2)_2]_2$. A sample of this material was placed in the reactor shown in Figure 1 in chamber 1. The pressure in chambers 1 and 2 was reduced to ca. $10^{-2}$Pa and the temperature in chamber 2 was raised to 650°C. Raising the source temperature (chamber 1) to 70°C caused sublimation (to a vapour pressure of the order of 1 Pa) of the sample which then decomposed on the heated substrates in chamber 2. In this way AlN was deposited as continuous, thin layers on silica glass and single crystal wafers of silicon, sapphire, gallium arsenide and indium phosphide.

This invention relates to a method of forming a layer of aluminium nitride using certain aluminium-nitrogen compounds. Aluminium nitride is of importance in semiconductor devices because of its high thermal conductivity and high electrical resistivity. It can thus be used as a passive barrier layer or substrate for electronic hybrid circuit technologies where good dissipation of the heat generated by the circuits is required.

Conventionally, bulk aluminium nitride is formed by ceramic processes involving high temperature sintering reactions which form a dense bulk material, which is difficult to make in thin (nanometres) layer form. Thin layers conventionally can be deposited by the reaction of inorganic aluminium compounds, such as the halides, which are volatile at high temperatures and react in the vapour phase with ammonia or similar nitrogen containing volatile compounds to form aluminium nitride. These vapour deposition processes are cumbersome, requiring complex reactors for deposition at the high temperatures, normally in excess of 1000°C, needed for the reaction to proceed. Such equipment is both costly and inappropriate for large scale operation needed for semiconductor applications.

Another route to aluminium nitride deposits was proposed by Takahashi et al in Surface Science 86(1979)238-245. Aluminium tris-dialkylamides $[Al(NR_2)_3]_2$ were decomposed at 300-500°C to yield a layer which, however, on analysis yielded oxygen and carbon as well as aluminium and nitrogen. In place of those compounds, it would be desirable to have a compound which was non-hazardous, crystalline and easily (but not too easily) decomposable.

It is known from Interrante in Materials Research Society Symposium Proceedings 73(1986)986 that the trimer $\{(CH_3)_2AlNH_2\}_3$ will deposit AlN, but that compound is difficult to volatilise and also ammonia is present during the deposition, which can affect the deposit.

According to the present invention, there is provided a method of forming a layer of aluminium nitride on a substrate, comprising heating the substrate to a compound-decomposition temperature and exposing it to a vapour of one or more compounds of the formula

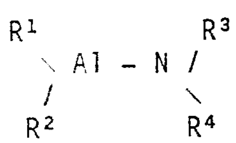

where $R_1$ and $R_2$ are independently ethyl or n-propyl and $R^3$ and $R^4$ are independently hydrogen, sec-butyl tertiary butyl or aryl.

Preferably at least one of $R^1$ and $R^2$ is ethyl. Preferably at least one of $R^3$ and $R^4$ is hydrogen.

The vapour preferably contains substantially nothing else, or at least no other reactant compounds, or at least no other reactant compounds containing aluminium and/or nitrogen. The compounds according to the invention generally are volatile and readily sublimed in vacuo at temperatures typically between 70°C or 80°C and 150°C to give a molecular stream which (in the method according to the invention) may be introduced into either an evacuated hot-walled reactor tube or passed within a containing tube over locally heated surfaces (substrates) on which the deposition is required. The form of this apparatus is similar to reactors used in the process of Metallo-Organic Chemical Vapour Deposition (MOCVD), but with the essential difference that the present process operates in a high vacuum, advantageously under conditions of Knudsen flow rather than in the viscous flow regime appropriate to the higher gas pressures typical of MOCVD. Thus, in the method according to the invention, the vapour pressure is preferably at most $10^2$Pa, and thus is in an intermediate range between molecular beam epitaxy (MBE - ultra-high vacuum, below $10^{-6}$ Torr, $10^{-4}$ Pa) and MOCVD (above 10 Torr, $10^3$Pa). As a result of introducing the vapour in a controlled manner (preferably at a pressure of at least $10^{-1}$ Pa) into the reactor, decomposition of the said compound occurs on the heated surfaces with the consequent formation of aluminium nitride films, aluminium and nitrogen atoms being of course delivered in precisely equal numbers at any point.

In the present invention, the compounds used in the method are preferably dialkyl aluminium dialkylamides. The alkyl groups attached to the aluminium are preferably groups which exert a shielding influence on the aluminium, minimising molecular interaction and leading to high volatility. It is important that these groups do not undergo a beta-elimination reaction which generally leads to decomposition paths resulting in the formation of metallic aluminium. Suitable groups are ethyl. The alkyl or aryl groups attached to the nitrogen are preferably those which do undergo β-elimination reactions in order that facile decomposition occurs between the temperatures 500°C and 900°C, e.g. isopropyl. Since the β-elimination reaction results in the loss of an alkene, leaving a hydrogen atom attached to the nitrogen atom in the precursor molecule, it is also possible to use the compounds dialkyl aluminium amide, i.e. $R^3 = R^4 = H$.

These compounds decompose at temperatures between 500°C and 800°C releasing both aluminium and nitrogen in equiatomic amounts forming layers of AlN. This binary compound is thus formed from a single precursor species and no other constituents or carrier gases are needed for film deposition.

This simplification compared with the conventional vapour deposition processes for AlN enables a simple and cheap apparatus, such as that to be described, to be used for film deposition.

The physical nature of the AlN films formed depends on the decomposition temperature and on the surfaces on which it is deposited. When using amorphous surfaces at the lower temperature end of the range, viz. 500°C to 550°C the films produced are amorphous or very finely polycrystalline, with a mean crystallite size typically less than 1 micrometer. For higher growth temperatures the films consist of larger crystallites, above 1

micrometer in diameter. If the surfaces used for deposition are single crystal wafers of semiconductor materials such as silicon or gallium arsenide the layers formed consist of oriented cubic crystallites or epitaxial single crystal layers. For the formation of continuous, high density films it is preferable to use wafers which have but a small thermal expansion mismatch with AlN. The substrate can however be any material which is not damaged at the temperature involved. Silicon, silica glass and sapphire are examples.

The invention will now be described by way of example with reference to the accompanying drawings, in which

Figure 1 is a diagrammatic representation of metallo-organic molecular beam epitaxy apparatus used in the method according to the invention, and

Figure 2 shows an alternative arrangement for the growth chamber, a part of the apparatus of Figure 1.

The form of apparatus appropriate to metallo organic molecular beam epitaxial (MOMBE) deposition is shown diagrammatically in Figure 1. The precursor (the 'compound') is contained in an evacuated chamber 1, connected directly to a decomposition chamber 2 in which the surfaces for coating are arranged in any convenient manner provided that they are accessible to the vapour stream originating from the chamber 1.

The precursor is vapourized by heating the chamber 1 to a temperature between 70°C and 150°C by means of a small thermostatically controlled oven 3. A larger electric furnace 4 is used to heat the surfaces on which deposition is required to temperatures between 500°C and 900°C. Chamber 2 is evacuated by means of a tube 5 through a trap 6, which can be immersed in liquid nitrogen or other appropriate coolants, which condense out any undecomposed precursor and reaction products. This trap can be isolated by means of valves 7 and 8 to allow disposal of the contents in a chemical work station. It is a feature of this method that no toxic materials or products need be involved. The apparatus is evacuated by means of rotary and diffusion pumps 9, 10, or by other types of high vacuum pumps such as molecular sieve, turbo molecular or titanium sublimation pumps.

An alternative version of the decomposition chamber 2 is shown in Figure 2 in which the surfaces to be coated with aluminium nitride films, 11, are locally heated by means of an infra-red lamp directed into the surfaces, or by means of a resistance heated plate or by an external radio frequency heating coil coupling to an internal susceptor 12. This arrangement has the advantage that decomposition of the precursor material does not occur on the reactor walls, and that a thermocouple 13 can be inserted into the susceptor or heat spreader to provide an accurate indication of the decomposition temperature for control purposes.

A particular feature of this apparatus is that the rate of volatilisation of the precursor material can be controlled by the temperature at which the precursor area is held by the oven 3. This enables the growth rate of the films to be controlled, which is important for reproducible operation of the equipment.

Furthermore, the thickness uniformity of the films is better than in conventional vapour phase deposition of AlN since the gas flows are not subject to hydrodynamic restrictions which result in boundary layer effects and severe vapour depletion along the length of the decomposition chamber. Films showing interference fringes less than 1 wavelength of sodium light in variation across a wafer of 25mm diameter have been reproducibly attained.

As an example of a suitable precursor material the compound diethylaluminium di-isopropylamide has been prepared and used for the growth of AlN films at 700°C which are dense, continuous and uniform which do not change their appearance after 48 hours' exposure to atmospheric moisture, and which adhere very strongly to the surfaces on which they were deposited. These surfaces include silica glass, silicon, sapphire gallium arsenide, indium phosphide, metallic nickel and molybdenum. The structure of the film on silicon was epitaxial; layers could be grown at substrate temperatures from 600°C upwards. Layers grown at 500°C are apparently amorphous but on closer inspection prove to be composed of very small crystallites. As atmospheric moisture can penetrate just a small distance into the aluminium nitride lattice and degrade it, this structure (not surprisingly) deteriorated visibly in air within 48 hours.

A specific method according to the invention will now be described by way of example.

A solution of diisopropylamine $NH(CHMe_2)_2$ (3.15g, 31.2mmol) in pentane ($20cm^3$) was transferred dropwise onto a solution of 30mmol $Et_3Al$ (2.3M solution in hexane) at -196°C. The contents were allowed to warm to 0°C and solvents were removed in vacuo to leave crude $Et_3Al.NH(CHMe_2)_2$. This was distilled at room temperature and 1Pa into a receiver flask at -78°C. The purified adduct was heated to 145°C under atmospheric pressure of nitrogen for one hour and the resulting solid was sublimed at 120°C/1Pa to give pure $[Et_2AlN(CHMe_2)_2]_2$. A sample of this material was placed in the reactor shown in Figure 1 in chamber 1. The pressure in chambers 1 and 2 was reduced to ca. $10^{-2}$Pa and the temperature in chamber 2 was raised to 700°C. Raising the source temperature (chamber 1) to 100°C caused sublimation (to a vapour pressure of the order of 1 Pa) of the sample which then decomposed on the heated substrates in chamber 2. In this way AlN was deposited as continuous, thin layers on silica glass and single crystal wafers of silicon, sapphire gallium arsenide and indium phosphide.

## Claims

1. A compound

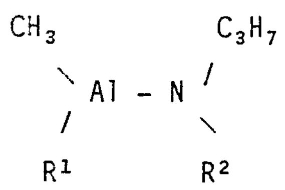

where $R^1$ is methyl, ethyl or n-propyl and $R^2$ is hydrogen, propyl, sec-butyl, tertiary butyl or aryl.

2. A compound according to Claim 1, wherein $R^1$ is methyl.

3. A compound according to Claim 1 or 2, wherein $R^2$ is isopropyl.

4. The compound

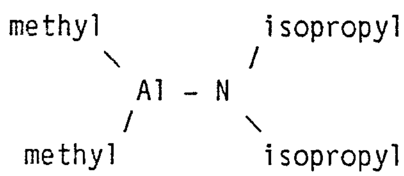

5. A compound being a polymer of a compound according to any preceding claim.

6. A method of forming a layer of aluminium nitride on a substrate, comprising heating the substrate to a compound-decomposition temperature and exposing it to a vapour of one or more compounds containing aluminium.

7. A method according to Claim 6, wherein the vapour contains no other compounds containing aluminium.

8. A method according to Claim 6 or 7, wherein the vapour contains no other compounds containing nitrogen.

9. A method according to Claim 6, wherein the vapour contains no other reactant.

10. A method according to Claim 6, wherein the vapour contains substantially nothing else.

11. A method according to any of Claims 6 to 10 wherein the vapour is generated by heating the compound at 70° C to 150° C.

12. A method according to any of Claims 6 to 11. wherein the substrate is held at a temperature of from 500° C to 900° C.

13. A method according to Claim 14, wherein the substrate temperature is up to 800° C

14. A method according to any of Claims 6 to 13, wherein the substrate is subject to Knudsen flow.

15. A method according to any of Claims 6 to 14 wherein the vapour pressure is from $10^{-1}$ Pa to $10^2$Pa.

16. A substrate on which an aluminium nitride film has been formed by a method according to any of Claims 6 to 15.

17. A method of forming a layer of aluminium nitride on a substrate, comprising heating the substrate to a compound-decomposition temperature and exposing it to a vapour of one or more compounds

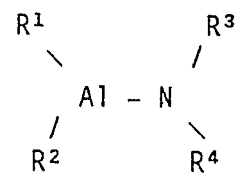

where $R^1$ and $R^2$ are independently ethyl or n-propyl, and $R^3$ and $R^4$ are independently hydrogen, sec-butyl, tertiary butyl or aryl.

18. A method according to Claim 17, wherein at least one of $R^1$ and $R^2$ is ethyl.

19. A method according to Claims 18 or 19, wherein at least one of $R^3$ and $R^4$ is H.

20. A method according to any preceding claim, wherein the compound is a polymer of the said formula.

21. A method according to any preceding claim, wherein the vapour contains no other compounds containing aluminium.

22. A method according to any preceding claim, wherein the vapour contains no other compounds containing nitrogen.

23. A method according to any of Claims 17 to 20, wherein the vapour contains no other reactant.

24. A method according to any of Claims 17 to 20, wherein the vapour contains substantially nothing else.

25. A method according to any preceding claim, wherein the vapour is generated by heating the compound at 70° C to 150° C.

26. A method according to any preceding claim, wherein the substrate is held at a temperature of from 500° C to 900° C.

27. A method according to Claim 26, wherein the substrate temperature is up to 800° C.

28. A method according to any preceding claim, wherein the substrate is subject to Knudsen flow.

29. A method according to any preceding claim, wherein the vapour pressure is from $10^{-1}$ Pa to $10^2$Pa.

30. A substrate on which an aluminium nitride film has been formed by a method according to any preceding claim.

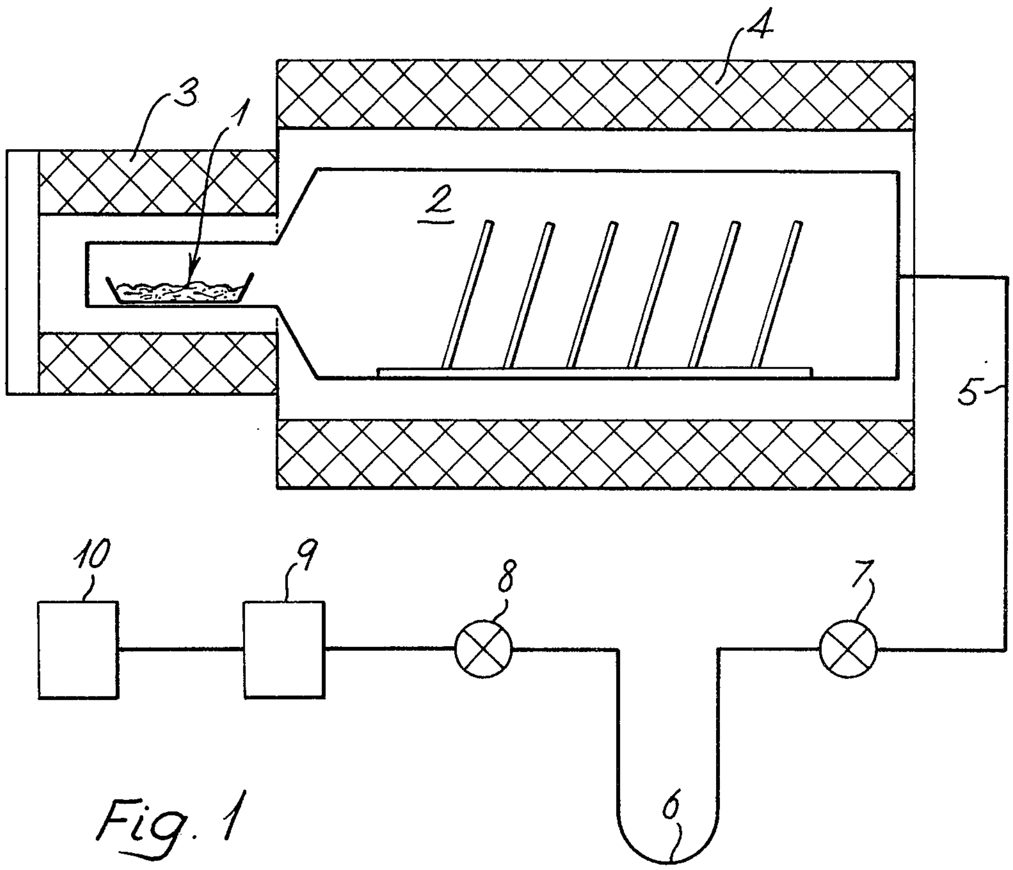


Fig. 1

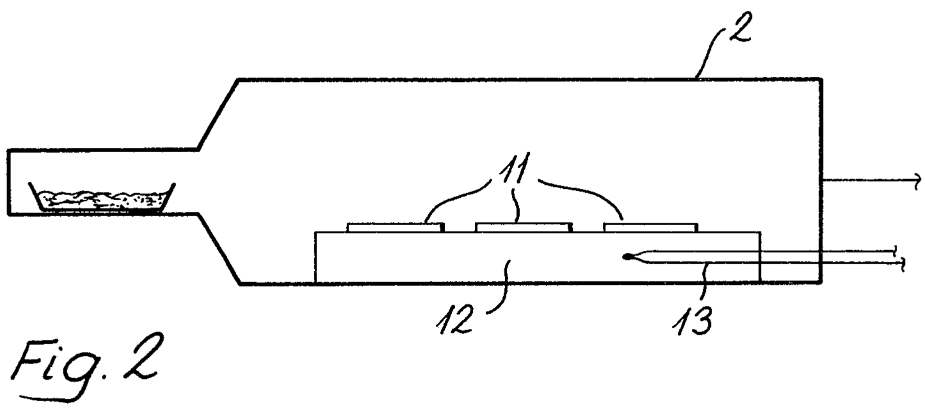


Fig. 2